# EUROPEAN PATENT APPLICATION

(11) **EP 4 746 118 A1**
(43) Date of publication of application: **20.05.2026**
(21) Application number: 25214609.7
(22) Date of filing: 10.11.2025
(51) Int. Cl.: H01M 10/48, G01R 31/392

(54) **METHOD FOR PREDICTING LIFE OF BATTERY AND BATTERY LIFE PREDICTION SYSTEM**

(30) Priority: 15.11.2024 KR 20240163165
(71) Applicant: SAMSUNG SDI CO., LTD., Yongin-si, Gyeonggi-do 17084 (KR)
(72) Inventor: KO, Younghoon, 17084 Yongin-si, Gyeonggi-do (KR); KIM, Haemin, 17084 Yongin-si, Gyeonggi-do (KR); LEE, Yujin, 17084 Yongin-si, Gyeonggi-do (KR); LEE, Dongryul, 17084 Yongin-si, Gyeonggi-do (KR); JANG, Junho, 17084 Yongin-si, Gyeonggi-do (KR); YI, Sangkoan, 17084 Yongin-si, Gyeonggi-do (KR); KWON, Youngwoong, 17084 Yongin-si, Gyeonggi-do (KR)
(74) Representative: Bardehle Pagenberg Partnerschaft mbB Patentanwälte Rechtsanwälte

(57) **Abstract**

Aspects herein relate to a method (S8oo) for predicting a life of a battery and a corresponding battery life prediction system (10). The method (S8oo) includes: acquiring (S810), by at least one processor (122), electrolyte data associated with a target battery; acquiring (S820), by the at least one processor (122), charge data associated with the target battery based on the electrolyte data; and predicting (S830), by the at least one processor (S122), a life of the target battery based on the charge data.

## Description

The present application claims priority to and the benefit of Korean Patent Application No. 10-2024-0163165 filed on November 15, 2024, the entire contents of which is incorporated by reference.

### BACKGROUND

### 1. Field

The present disclosure relates to a method for predicting a life of a battery, and a battery life prediction system.

### 2. Description of the Related Art

Unlike primary batteries that are not designed to be (re)charged, secondary (or rechargeable) batteries are batteries that are designed to be discharged and recharged. Low-capacity secondary batteries are for example used in portable, small electronic devices, such as smart phones, feature phones, notebook computers, digital cameras, and camcorders, while large-capacity secondary batteries are for example widely used as power sources for driving motors in hybrid vehicles and electric vehicles and for storing power (e.g., home and/or utility scale power storage). A secondary battery may generally include an electrode assembly composed of a positive electrode and a negative electrode, a case accommodating the same, and electrode terminals connected to the electrode assembly.

When a battery is developed, repeated charging and discharging may be performed for various conditions and durations, similar to those of an actual usage environment of the battery. By measuring the battery's life (or its remaining charge capacity) in such a way, the battery's long-term life may be predicted, and the battery's life may be evaluated at the same time. However, such an approach for evaluating the battery's life may take a long time and may be cumbersome. Accordingly, it may be desirable to reduce the time required to evaluate the battery's life, while enabling early detection of battery defects through a battery life prediction approach.

The above information disclosed in this Background section is for enhancement of understanding of the background of the present disclosure, and therefore, it may contain information that does not constitute related (or prior) art.

### SUMMARY

Aspects of the present disclosure relate to a method for predicting a life of a battery, and a battery life prediction system.

These and other aspects and features of the present disclosure will be described in or will be apparent from the following description of embodiments of the present disclosure.

A first aspect relates to a method for predicting a life of a battery. The method includes: acquiring, by at least one processor, electrolyte data associated with a target battery; acquiring, by the at least one processor, charge data associated with the target battery based on the electrolyte data; and predicting, by the at least one processor, a life of the target battery based on the charge data.

In some embodiments, the electrolyte data may include a capacity of an electrolyte injected into the target battery.

In addition, or alternatively, the method may further include: acquiring, by the at least one processor, first electrolyte data associated with a first battery; acquiring, by the at least one processor, second electrolyte data associated with a second battery; acquiring, by the at least one processor, first charge data associated with the first battery; and acquiring, by the at least one processor, second charge data associated with the second battery. The acquiring of the charge data associated with the target battery may include estimating, by the at least one processor, the charge data associated with the target battery based on the first electrolyte data, the second electrolyte data, the first charge data, the second charge data, and the electrolyte data associated with the target battery.

In addition, or alternatively, the estimating of the charge data associated with the target battery may include estimating, by the at least one processor, a linear function representing a relationship between an amount of an electrolyte injected into the target battery and a charge capacity, based on the first electrolyte data, the second electrolyte data, the first charge data, and the second charge data.

In addition, or alternatively, the estimating of the charge data associated with the target battery may further include calculating, by the at least one processor, the charge data associated with the target battery based on the electrolyte data associated with the target battery and the linear function.

In addition, or alternatively, the linear function may be estimated through an extrapolation method.

In addition, or alternatively, the first charge data may include a value obtained by accumulating at least part of a charge capacity of the first battery over one charge-discharge cycle, as charge-discharge cycles of the first battery are repeated. The second charge data may include a value obtained by accumulating at least part of a charge capacity of the second battery over one charge-discharge cycle, as charge-discharge cycles of the second battery are repeated.

In addition, or alternatively, the value obtained by accumulating the at least part of the charge capacity of the first battery over one charge-discharge cycle may be a value obtained by accumulating, in a section among multiple sections included in the one charge-discharge cycle, the charge capacity of the first battery as charge-discharge cycles of the first battery are repeated. The value obtained by accumulating the at least part of the charge capacity of the second battery over one charge-discharge cycle may be a value obtained by accumulating, in the section among multiple sections included in the one charge-discharge cycle, the charge capacity of the second battery as charge-discharge cycles of the second battery are repeated. A charging speed in the section may be the fastest among charging speeds of each of the multiple sections included in the charge-discharge cycle.

In addition, or alternatively, the predicting of the life of the target battery may include estimating, by the at least one processor, a reference graph representing a relationship between a repetition count of the charge-discharge cycle and a value obtained by accumulating the battery's charge capacity in the section among the multiple sections included in the one charge-discharge cycle, as the charge-discharge cycle is repeated, based on at least one of the first charge data or the second charge data.

In addition, or alternatively, the predicting of the life of the target battery may further include: acquiring, by the at least one processor, third charge data associated with a third battery, the third charge data being a value obtained by accumulating, in the section among multiple sections included in the one charge-discharge cycle, a charge capacity of the third battery, as charge-discharge cycles of the third battery are repeated; acquiring, by the at least one processor, fourth charge data associated with a fourth battery, the fourth charge data being a value obtained by accumulating, in the section among multiple sections included in the one charge-discharge cycle, a charge capacity of the fourth battery, as charge-discharge cycles of the fourth battery are repeated; estimating, by the at least one processor, a comparison graph representing a relationship between the repetition count of the charge-discharge cycle and a value obtained by accumulating the battery's charge capacity in the section among the multiple sections included in the one charge-discharge cycle, as the charge-discharge cycle is repeated, based on at least one of the third charge data or the fourth charge data; and generating, by the at least one processor, a corrected graph by correcting the reference graph based on the reference graph and the comparison graph.

In addition, or alternatively, the predicting of the life of the target battery may further include estimating, by the at least one processor, the life of the target battery based on the estimated charge data associated with the target battery and the corrected graph.

In addition, or alternatively, the method may further include determining, by the at least one processor, whether or not to ship the target battery based on the predicted life of the target battery.

In some embodiments, the determining of whether or not to ship the target battery may include: determining, by the at least one processor, whether or not the predicted life of the target battery is greater than or equal to a threshold; and in response to determining that the predicted life of the target battery is greater than or equal to the threshold, transmitting, by the at least one processor, a command to a battery-manufacturing apparatus to ship the target battery.

In addition, or alternatively, a non-transitory computer-readable recording medium may store a computer program for executing the method.

A further aspect relates to a battery life prediction system. The battery life prediction system includes: a memory; and at least one processor connected to the memory, and configured to execute at least one computer-readable program included in the memory. The at least one computer-readable program includes instructions that, when executed by the at least one processor, cause the at least one processor to: acquire electrolyte data associated with a target battery; acquire charge data associated with the target battery based on the electrolyte data; and predict a life of the target battery based on the charge data.

In some embodiments, the at least one program may further include instructions that cause the at least one processor to: acquire first electrolyte data associated with a first battery; acquire second electrolyte data associated with a second battery; acquire first charge data associated with the first battery; acquire second charge data associated with the second battery; and estimate charge data associated with the target battery based on the first electrolyte data, the second electrolyte data, the first charge data, the second charge data, and the electrolyte data associated with the target battery.

In addition, or alternatively, the at least one program may further include instructions that cause the at least one processor to: estimate a linear function representing a relationship between an amount of an electrolyte injected into the target battery and a charge capacity, based on the first electrolyte data, the second electrolyte data, the first charge data, and the second charge data; and calculate the charge data associated with the target battery based on the electrolyte data associated with the target battery and the linear function.

In addition, or alternatively, the at least one program may further include instructions that cause the at least one processor to: estimate a reference graph representing a relationship between a repetition count of a charge-discharge cycle and a value obtained by accumulating the battery's charge capacity in a section among multiple sections included in one charge-discharge cycle, as the charge-discharge cycle is repeated, based on at least one of the first charge data or the second charge data. A charging speed in the section may be the fastest among charging speeds of each of the multiple sections included in the charge-discharge cycle.

In addition, or alternatively, the at least one program may further include instructions that cause the at least one processor to estimate the life of the target battery based on the estimated charge data associated with the target battery and the reference graph.

In addition, or alternatively, the at least one program may further include instructions that cause the at least one processor to: determine whether or not to ship the target battery based on the predicted life of the target battery; and transmit a command to a battery-manufacturing apparatus to ship the target battery.

In addition, or alternatively, charge data associated with a target battery may be estimated based on electrolyte data associated with the target battery, and the life of the target battery may be estimated based on the estimated charge data associated with the target battery. Accordingly, it may be possible to predict the life of the target battery from a value of the electrolyte data associated with the target battery, and thus, it may be possible to verify, in a shorter time, whether or not the target battery meets the required or desired performance.

In addition, or alternatively, whether or not the target battery's specifications are satisfied may be experimentally determined without an actual measurement, and the time and costs that may typically be consumed for a battery life evaluation may be reduced.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
FIG. 1 illustrates a schematic diagram of a battery life prediction system according to an embodiment of the present disclosure.
FIG. 2 is a block diagram illustrating an internal configuration of a processor according to an embodiment of the present disclosure.
FIG. 3 illustrates a process for predicting the life of a target battery according to an embodiment of the present disclosure.
FIG. 4 illustrates a cause of a difference in the life spans of batteries that have the same or substantially the same design specifications as each other.
FIG. 5 illustrates multiple charging sections included in a charging pattern.
FIG. 6 illustrates a relationship between an amount of an electrolyte injected and a charge capacity.
FIG. 7 illustrates a relationship between an amount of an electrolyte injected and the life of a battery.
FIG. 8 illustrates a flowchart showing an example of a battery life prediction method according to an embodiment of the present disclosure.
FIG. 9 illustrates a flowchart showing an example of an operation for acquiring charge data associated with a target battery according to an embodiment of the present disclosure.

### DETAILED DESCRIPTION

Hereinafter, embodiments of the present disclosure will be described, in detail, with reference to the accompanying drawings. The terms or words used in the present specification and claims are not to be limitedly interpreted as general or dictionary meanings and should be interpreted as meanings and concepts that are consistent with the technical idea of the present disclosure on the basis of the principle that an inventor can be his/her own lexicographer to appropriately define concepts of terms to describe his/her invention in the best way.

The embodiments described in this specification and the configurations shown in the drawings are only some of the embodiments of the present disclosure and do not represent all of the technical scope, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

In this specification, unless clearly defined as singular in context, the singular expression includes a plural expression. Also, unless clearly defined as plural in context, the plural expression includes a singular expression. Throughout the specification, when a portion is described as including a certain component, it means that the portion may further include other components, rather than excluding other components, unless specifically described otherwise.

In addition, the terms "module" or "unit," as used in this specification, refer to software or hardware components that perform certain roles. However, the term "module" or "unit" is not limited to software or hardware. A "module" or "unit" may be configured to reside in an addressable storage medium and may be configured to reproduce one or more processors. Thus, for example, a "module" or "unit" may include, at least one of software components such as object-oriented software components, class components, and task components, and processes, functions, attributes, procedures, subroutines, segments of program code, drivers, firmware, microcode, circuits, data, databases, data structures, tables, arrays, or variables. The functions provided within components and "modules" or "units" may be combined into fewer components and "modules" or "units" or further separated into additional components and "modules" or "units."

According to an embodiment of the present disclosure, a "module" or "unit" may be implemented with a processor and a memory. The term "processor" should be broadly interpreted to include, for example, a general-purpose processor, a central processing unit (CPU), a microprocessor, a digital signal processor (DSP), a controller, a microcontroller, or a state machine. In certain environments, a "processor" may refer to an application-specific integrated circuit (ASIC), a programmable logic device (PLD), a field-programmable gate array (FPGA), etc. A "processor" may also refer to a combination of processing devices, such as a combination of a DSP and a microprocessor, a combination of multiple microprocessors, a combination of one or more microprocessors combined with a DSP core, or any other such configuration. Also, a "memory" should be broadly interpreted to include any electronic component capable of storing electronic information. A "memory" may refer to various types of processor-readable media, such as random access memory (RAM), read-only memory (ROM), non-volatile random access memory (NVRAM), programmable read-only memory (PROM), erasable programmable read-only memory (EPROM), electrically erasable PROM (EEPROM), flash memory, magnetic or optical data storage devices, registers, and the like. A memory is said to be in electronic communication with a processor if the processor can read information from and/or write information to the memory. A memory integrated into a processor is in electronic communication with the processor.

In the present disclosure, a "system" may include at least one of a server device and a cloud device, but is not limited thereto. For example, the system may be configured of one or more server devices. In another example, the system may be configured of one or more cloud devices. In yet another example, the system may operate with a server device and a cloud device configured together.

In the present disclosure, the sizes and relative sizes of the regions shown in the drawings may be exaggerated for clarity of description. That is, the sizes shown in the drawings are merely for convenience in understanding and are not limiting. Also, the flowcharts and accompanying descriptions shown in the drawings are merely examples, and may be implemented differently in some embodiments. For example, one or more steps may be omitted, the order of the steps may be changed, one or more steps may be performed in an overlapping manner, or one or more steps may be repeated multiple times.

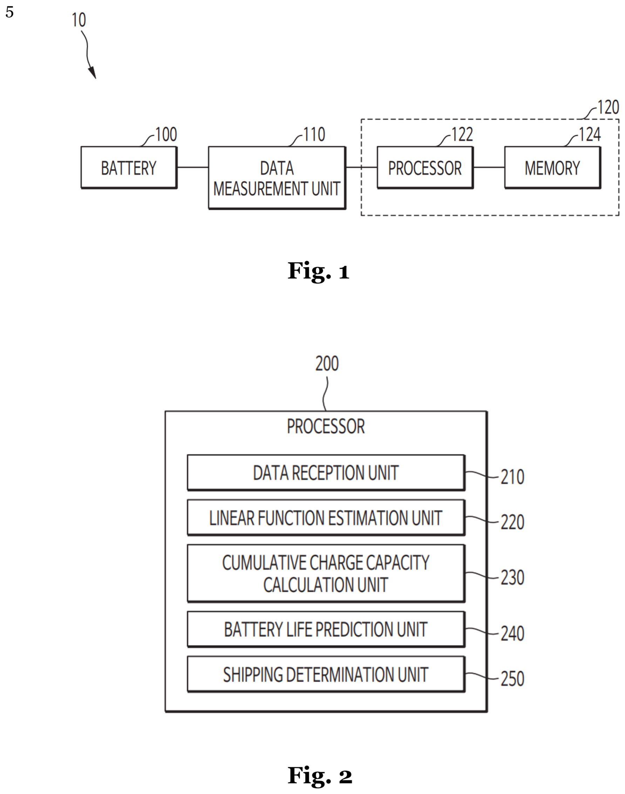

FIG. 1 is a schematic diagram of a battery life prediction system 10 according to an embodiment of the present disclosure.

Referring to FIG. 1, the battery life prediction system 10 may include a battery 100, a data measurement unit 110, and an information processing system 120. The information processing system 120 may include a processor 122 and a memory 124.

The battery 100 may include a rechargeable secondary cell. For example, the battery 100 may include a nickel-cadmium battery, a lead storage battery, a nickel-metal hydride (NiMH) battery, a lithium ion battery, or a lithium polymer battery.

The data measurement unit 110 may monitor the battery 100 to acquire data. For example, the data measurement unit 110 may charge or discharge the battery 100 to acquire charge data or discharge data of the battery 100. The data measurement unit 110 may periodically or non-periodically monitor the battery 100 in real time or at suitable intervals (e.g., predetermined intervals) to acquire data, and may transmit the acquired data to the processor 122 and/or the memory 124.

The data measurement unit 110 may include a charge-discharge device capable of charging or discharging the battery 100. The charge-discharge device may include a charger and a discharger. For example, the data measurement unit 110 may be disposed inside an electronic device, and may include a charge-discharge device provided in the electronic device, or may be disposed outside the electronic device. The charge-discharge device may charge or discharge the battery 100 by varying a charge-discharge rate (e.g., a C-Rate). The charge-discharge rate may be a value obtained by dividing the size of the charge-discharge current of the battery 100 by the rated capacity of the battery 100. For example, the charger may charge the battery 100 at a first charging rate. Also, the charger may charge the battery 100 at a second charging rate, which differs from the first charging rate. For example, the second charging rate may be slower than the first charging rate. Further, before the battery 100 is charged by the charger, the battery 100 may be discharged by the discharger. In addition, during one charge-discharge cycle, the data measurement unit 110 may charge the battery 100 by varying the charging rate. As used herein, one charge-discharge cycle may refer to one cycle in which the fully charged battery 100 is discharged and then recharged.

During one charge-discharge cycle in which the battery 100 is charged or discharged, the data measurement unit 110 may acquire charge data related to the charge capacity of the battery 100. In addition, when the battery 100 is charged at different charging rates during one charge-discharge cycle, the data measurement unit 110 may acquire charge data related to the charge capacity corresponding to each charging-rate section. For example, if (e.g., when) the battery 100 in a discharged state is charged first at a first charging rate, then is charged at a second charging rate, the data measurement unit 110 may acquire first charge data related to the charge capacity in a section corresponding to the first charging rate and second charge data related to the charge capacity in a section corresponding to the second charging rate. Also, the data measurement unit 110 may periodically or non-periodically transmit the acquired charge data to the processor 122 and/or the memory 124 in real time or at suitable intervals (e.g., predetermined intervals).

The processor 122 may include, for example, a general-purpose processor, a central processing unit (CPU), a microprocessor, a digital signal processor (DSP), a controller, a microcontroller, or a state machine. In some environments, the processor 122 may refer to an application-specific integrated circuit (ASIC), a programmable logic device (PLD), a field-programmable gate array (FPGA), and/or the like. The processor 122 may also refer to a combination of processing devices, such as a combination of a DSP and a microprocessor, a combination of multiple microprocessors, a combination of one or more microprocessors combined with a DSP core, or any other suitable configuration.

The processor 122 may process instructions of a computer program by performing basic arithmetic, logic, and input/output operations. In some embodiments, the processor 122 may receive data regarding the battery 100 from the data measurement unit 110. The processor 122 may predict the life of the battery 100 based on the received data. The data regarding the battery 100 received by the processor 122, or battery life prediction data generated by the processor 122 and the like, may be stored in the memory 124. Also, based on data regarding the predicted life of the battery 100, the processor 122 may determine whether or not the battery 100 is to be shipped. The processor 122 may transmit a command to ship the battery 100 to a battery-manufacturing apparatus. Data regarding whether or not the battery 100 is to be shipped, as determined by the processor 122, may be stored in the memory 124.

The memory 124 may include any suitable electronic component capable of storing electronic information. The memory 124 may refer to various suitable kinds of processor-readable media, such as random access memory (RAM), read-only memory (ROM), non-volatile random access memory (NVRAM), programmable read-only memory (PROM), erasable programmable read-only memory (EPROM), electrically erasable PROM (EEPROM), flash memory, magnetic or optical data storage devices, registers, and/or the like. The memory 124 may be in electronic communication with the processor 122 if (e.g., when) the processor 122 can read information from and/or write information to the memory 124. A memory integrated into the processor 122 is in electronic communication with the processor 122.

In some embodiments, the memory 124 may include any suitable non-transitory computer-readable recording medium. According to some embodiments, the memory 124 may include a permanent mass storage device. As another example, the permanent mass storage device may be a separate permanent storage device distinguished from the memory 124, and may be included in the battery life prediction system 10, or may be included in a device accessible by the battery life prediction system 10 through a wired or wireless connection. As another example, the memory 124 may be implemented as part of the processor 122.

In some embodiments, the memory 124 may store an operating system and at least one program code (e.g., program code for predicting the life of a battery). Also, the memory 124 may store charge data related to the battery 100, the battery life prediction data of the battery 100, the data regarding whether or not the battery 100 is to be shipped, and/or the like.

Additionally, the information processing system 120 may further include a communication module (e.g., a communication channel). The communication module may provide a configuration or a function for communicating with the data measurement unit 110, and may provide a configuration or a function for the information processing system 120 to communicate with external devices or external systems. For example, a control signal, a command, data, and/or the like provided under the control of the information processing system 120 may be transmitted to the charge-discharge device of the data measurement unit 110, external devices, and/or external systems via the communication module. Similarly, control signals, commands, data, and/or the like provided by the charge-discharge device, external devices, and/or external systems may be transmitted to the information processing system 120 through the communication module.

FIG. 2 is a block diagram illustrating an internal configuration of a processor 200 according to an embodiment of the present disclosure.

Referring to FIG. 2, the processor 200 may include a data reception unit 210, a linear function estimation unit 220, a cumulative charge capacity calculation unit 230, a battery life prediction unit 240, and a shipping determination unit 250. For example, the processor 200 may correspond to the processor 122 included in the information processing system 120 described above with reference to FIG. 1.

The data reception unit 210 may receive data regarding a battery monitored by the data measurement unit (e.g., the data measurement unit 110 in FIG. 1). For example, the data reception unit 210 may receive charge data related to a charge capacity of the battery over one charge-discharge cycle as monitored by the data measurement unit. Additionally or as another example, when the battery is charged at varying charging speeds during one charge-discharge cycle, the data reception unit 210 may receive charge data related to the charge capacity for each charging-speed section. The data reception unit 210 may periodically or non-periodically receive monitored data of the battery from the data measurement unit in real time or at suitable intervals (e.g., predetermined intervals). The data reception unit 210 may transmit the received data to at least some of the other components within the processor 200.

In addition, the data reception unit 210 may receive electrolyte data corresponding to each battery. In some embodiments, the electrolyte data may include a capacity of an electrolyte injected into the battery. For example, the data reception unit 210 may receive the capacity of the electrolyte injected when the battery is manufactured. The data reception unit 210 may receive from a memory (e.g., the memory 124 in FIG. 1) the electrolyte data corresponding to each battery, or may receive the electrolyte data corresponding to each battery from an external device communicable with the processor 200. In other words, the data reception unit 210 may receive the electrolyte data corresponding to each battery. The data reception unit 210 may transmit the received data to at least some of the other components of the processor 200.

The linear function estimation unit 220 may receive battery-related data from the data reception unit 210. For example, the linear function estimation unit 220 may receive first charge data associated with a first battery and second charge data associated with a second battery from the data reception unit 210. Also, the linear function estimation unit 220 may receive first electrolyte data associated with the first battery, second electrolyte data associated with the second battery, and electrolyte data associated with a target battery from the data reception unit 210. The target battery may refer to a battery having a life that is to be predicted, and the first battery and the second battery may serve as references for predicting the life of the target battery.

In some embodiments, the linear function estimation unit 220 may estimate a linear function representing a relationship between an amount of an electrolyte injected into the target battery and a charge capacity, based on the first charge data, the second charge data, the first electrolyte data, and the second electrolyte data. In some embodiments, the linear function estimation unit 220 may estimate the linear function using extrapolation. Extrapolation, also referred to as a method of "exterior interpolation," is a mathematical method of estimating the value of a variable beyond the original observation range based on a relationship with another variable. In other words, it is a method of estimating data values in an unobserved range based on the relationship of collected data values. The linear function estimation unit 220 may transmit the estimated linear function and the electrolyte data associated with the target battery to at least some of the other components in the processor 200.

In some embodiments, the first charge data may include a value obtained by accumulating at least part of a charge capacity of the first battery over one charge-discharge cycle, as the charge-discharge cycles of the first battery are repeated. The second charge data may include a value obtained by accumulating at least part of a charge capacity of the second battery over one charge-discharge cycle, as the charge-discharge cycles of the second battery are repeated. In more detail, the first charge data may be a value obtained by accumulating, in a suitable section (e.g., a predetermined section) among multiple sections included in one charge-discharge cycle, the charge capacity of the first battery as the charge-discharge cycles of the first battery are repeated. The second charge data may be a value obtained by accumulating, in the section (e.g., the predetermined section) among multiple sections included in one charge-discharge cycle, the charge capacity of the second battery as the charge-discharge cycles of the second battery are repeated. The charging speed in the section may be the fastest among the charging speeds in each of the multiple sections included in the charge-discharge cycle.

The cumulative charge capacity calculation unit 230 may receive the estimated linear function and the electrolyte data associated with the target battery from the linear function estimation unit 220. The cumulative charge capacity calculation unit 230 may calculate the charge data associated with the target battery based on the estimated linear function and the electrolyte data associated with the target battery. For example, the cumulative charge capacity calculation unit 230 may substitute the capacity value of the electrolyte injected into the target battery into the estimated linear function to calculate the charge data associated with the target battery. The charge data associated with the target battery may include a value that is estimated as the cumulative value, over repeated charge-discharge cycles of the target battery, of the charge capacity in the section among multiple sections included in one charge-discharge cycle. The cumulative charge capacity calculation unit 230 may transmit the calculated charge data associated with the target battery to at least some of the other components in the processor 200.

The battery life prediction unit 240 may receive the charge data associated with the target battery from the cumulative charge capacity calculation unit 230. Also, the battery life prediction unit 240 may receive the first charge data associated with the first battery and the second charge data associated with the second battery from the data reception unit 210.

The battery life prediction unit 240 may estimate a reference graph representing a relationship between a repetition count of the charge-discharge cycle and a value obtained by accumulating the battery's charge capacity in a suitable section (e.g., a predetermined section) among multiple sections included in one charge-discharge cycle, as the charge-discharge cycle is repeated, based on at least one of the first charge data or the second charge data. For example, on the reference graph, the X-axis may represent the repetition count of the charge-discharge cycle, and the Y-axis may represent the cumulative value of the battery's charge capacity in the section among multiple sections included in one charge-discharge cycle, as the charge-discharge cycle is repeated. The charging speed in the section (e.g., the predetermined section) may be the fastest among the charging speeds in each of the multiple sections included in the charge-discharge cycle.

The battery life prediction unit 240 may predict the life of the target battery based on the charge data associated with the target battery and the estimated reference graph. For example, the battery life prediction unit 240 may substitute the cumulative value of the charge capacity associated with the target battery into the estimated reference graph, to obtain an estimated repetition count of the target battery's charge-discharge cycle. Also, the battery life prediction unit 240 may determine the obtained estimated repetition count of the target battery's charge-discharge cycle as the predicted life of the target battery. The battery life prediction unit 240 may transmit the estimated life data associated with the target battery to at least some of the other components in the processor 200.

In addition, the battery life prediction unit 240 may acquire third charge data associated with a third battery and fourth charge data associated with a fourth battery. The third charge data may include a value obtained by accumulating the charge capacity of the third battery in the section (e.g., the predetermined section) among multiple sections included in one charge-discharge cycle, as the charge-discharge cycles of the third battery are repeated. The fourth charge data may include a value obtained by accumulating the charge capacity of the fourth battery in the section (e.g., the predetermined section) among multiple sections included in one charge-discharge cycle, as the charge-discharge cycles of the fourth battery are repeated.

The battery life prediction unit 240 may estimate a comparison graph representing a relationship between the repetition count of the charge-discharge cycle and a value obtained by accumulating the battery's charge capacity in the section (e.g., the predetermined section) among multiple sections included in one charge-discharge cycle, as the charge-discharge cycle is repeated, based on at least one of the third charge data or the fourth charge data. Also, the battery life prediction unit 240 may generate a corrected graph by correcting the reference graph based on the reference graph and the comparison graph, and may predict the life of the target battery based on the charge data associated with the target battery and the generated corrected graph.

The shipping determination unit 250 may receive the life data associated with the target battery from the battery life prediction unit 240. The shipping determination unit 250 may determine whether or not to ship the target battery based on the predicted life of the target battery. In more detail, the shipping determination unit 250 may determine whether or not the predicted life of the target battery is greater than or equal to a threshold (e.g., a predetermined threshold), and in response to determining that the predicted life of the target battery is greater than or equal to the threshold, the shipping determination unit 250 may transmit a command to a battery-manufacturing apparatus to ship the target battery. The threshold may be determined based on required or desired specifications for the battery.

In FIG. 2, each component of the processor 200 represents a functionally of distinguishable elements. In an actual physical environment, multiple components may be integrated into a single unit (e.g., a single chip). As another example, each component of the processor 200 may be implemented separately in an actual physical environment. Also, although FIG. 2 shows a single processor, the processor 200 may be implemented as a multi-core processor including multiple processors (or cores).

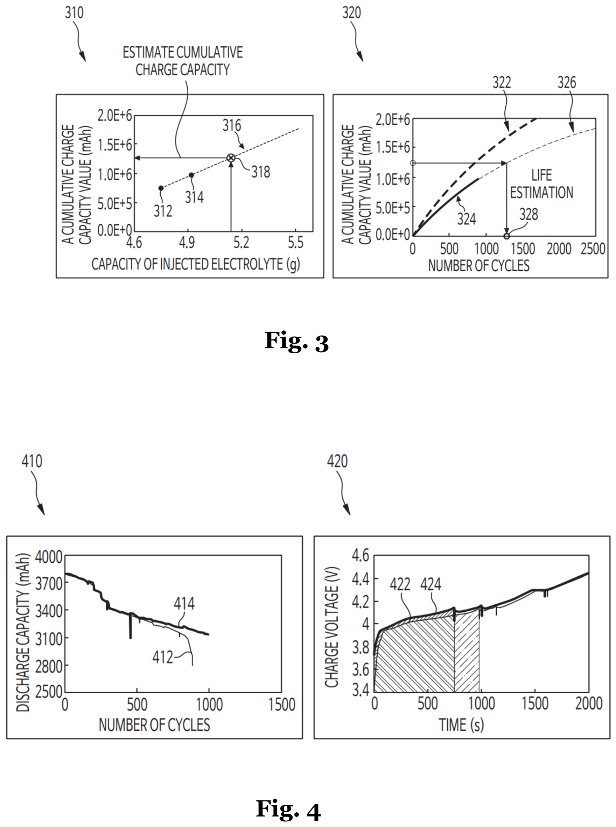

FIG. 3 illustrates a process for predicting the life of a target battery according to an embodiment of the present disclosure.

Referring to FIG. 3, the process for predicting the life of the target battery may be performed based on a first graph 310 and a second graph 320.

The first graph 310 may be a graph illustrating a relationship between an amount of an electrolyte solution injected into a battery and a cumulative charge capacity value. In more detail, in the first graph 310, the X-axis may represent the capacity of the electrolyte injected into the battery, and the Y-axis may represent a value obtained by accumulating the charge capacity over repeated charge-discharge cycles of the battery in a suitable section (e.g., a predetermined section) among multiple sections included in one charge-discharge cycle. The charging speed in the section (e.g., the predetermined section) may be the fastest among the charging speeds of the multiple sections included in the charge-discharge cycle.

First, based on the electrolyte data associated with a first battery and the charge data associated with the first battery, a first coordinate 312 may be obtained. Also, based on the electrolyte data associated with a second battery and the charge data associated with the second battery, a second coordinate 314 may be obtained. Then, based on the first coordinate 312 and the second coordinate 314, a linear function 316 may be estimated. The linear function 316 may be estimated through extrapolation. In addition, based on the electrolyte data associated with the target battery, a third coordinate 318 corresponding to the electrolyte data associated with the target battery may be obtained on the linear function 316. Based on the obtained third coordinate 318, the charge data associated with the target battery may be estimated.

The second graph 320 is a graph illustrating a relationship between the repetition count of the charge-discharge cycle and a cumulative charge capacity value. In more detail, in the second graph 320, the X-axis may represent the repetition count of the charge-discharge cycle. The repetition count of the charge-discharge cycle may refer to a count of repeated charge-discharge cycles from the Beginning of Life (BOL) stage of the battery until a point at which the battery is determined to enter the End of Life (EOL) stage. Also, in the second graph 320, the Y-axis may represent the value obtained by accumulating the battery's charge capacity in a suitable section (e.g., a predetermined section) among multiple sections included in one charge-discharge cycle, as the charge-discharge cycle is repeated. The charging speed in the section (e.g., the predetermined section) may be the fastest among the charging speeds of the multiple sections included in the charge-discharge cycle.

First, based on at least one of the first charge data or the second charge data, a reference graph 322 may be estimated. The reference graph 322 may represent a relationship between the repetition count of the charge-discharge cycle and a value obtained by accumulating the battery's charge capacity in a suitable section (e.g., a predetermined section) among multiple sections included in one charge-discharge cycle, as the charge-discharge cycle is repeated.

Also, based on at least one of the third charge data associated with the third battery or the fourth charge data associated with the fourth battery, a comparison graph 324 may be estimated. The comparison graph 324 may represent a relationship between the repetition count of the charge-discharge cycle and a value obtained by accumulating the battery's charge capacity in a suitable section (e.g., a predetermined section) among multiple sections included in one charge-discharge cycle, as the charge-discharge cycle is repeated. Referring to the second graph 320, the repetition count of the charge-discharge cycle in the comparison graph 324 may be smaller than that in the reference graph 322. The third battery and the fourth battery may include batteries having design specifications that are the same or substantially the same as those of the target battery.

Further, based on the reference graph 322 and the comparison graph 324, a corrected graph 326 may be generated by correcting the reference graph 322. In some embodiments, the corrected graph 326 may be estimated through regression analysis. For example, after analyzing a correlation between the reference graph 322 and the comparison graph 324, a linear or non-linear function representing the correlation may be derived, and the corrected graph 326 may be estimated based on the derived linear or non-linear function. As another example, after analyzing the correlation between the reference graph 322 and the comparison graph 324, a weight to be multiplied by the reference graph 322 may be determined based on the analyzed correlation, and by multiplying the reference graph 322 by the weight, the corrected graph 326 may be estimated. However, the present disclosure is not limited to the above methods of estimating the corrected graph 326.

Further, based on the estimated corrected graph 326, the life of the target battery may be estimated. In more detail, based on the charge data associated with the target battery, a fourth coordinate 328 may be obtained on the corrected graph 326, corresponding to the repetition count of the charge-discharge cycle of the target battery. Based on the obtained fourth coordinate 328, an estimated value of the repetition count of the target battery's charge-discharge cycle may be obtained. Further, the estimated value of the repetition count of the target battery's charge-discharge cycle may be determined as the estimated life of the target battery.

According to some embodiments of the present disclosure, the charge data associated with the target battery may be estimated based on the electrolyte data associated with the target battery, and the life of the target battery may be estimated based on the charge data associated with the target battery. As such, it may be possible to predict the life of the target battery from only the electrolyte data value associated with the target battery, and to verify, in a shorter period, whether or not the target battery meets a performance required or desired by a customer. Therefore, whether or not the target battery's specifications are satisfied may be experimentally determined without an actual measurement, and the time and costs that may be consumed in a comparative long-term life evaluation may be reduced.

FIG. 4 illustrates a cause of a difference in life spans of batteries with the same or substantially the same design specifications as each other.

Referring to FIG. 4, a first graph 410 is a graph illustrating the relationship between the repetition count of the charge-discharge cycle and a discharge capacity value. In more detail, in the first graph 410, the X-axis represents the repetition count of the charge-discharge cycle, and the Y-axis may represent the discharge capacity value during the charge-discharge cycle. Further, a first curve 412 may represent the discharge capacity associated with a first battery, and a second curve 414 may represent the discharge capacity associated with a second battery. Here, the design specification of the first battery may be the same or substantially the same as that of the second battery.

Referring to the first graph 410, the discharge capacity of the first battery decreases earlier than that of the second battery. In other words, the life of the first battery may be shorter than the life of the second battery. The life of the battery refers to a period from the BOL stage to the EOL stage, and the EOL stage refers to a point at which the charge capacity or discharge capacity during the battery's charge-discharge cycle decreases to less than or equal to a threshold (e.g., a predetermined threshold).

A second graph 420 is a graph illustrating differences in charging patterns of the first battery and the second battery. In the second graph 420, a third curve 422 represents the charging pattern associated with the first battery, and a fourth curve 424 represents the charging pattern associated with the second battery. In the charging patterns in which the first battery and the second battery are charged, the charging rate in each section may differ. Here, among multiple charging sections included in the charging patterns of the first and second batteries, the charging speed in the first-charged section may be the fastest. According to the second graph 420, the first section (e.g., the earliest section) of the charging patterns for the first battery and the second battery shows a difference in charging times. This confirms that the charging time in the first section of the charging pattern exerts a dominant influence on the life of the battery.

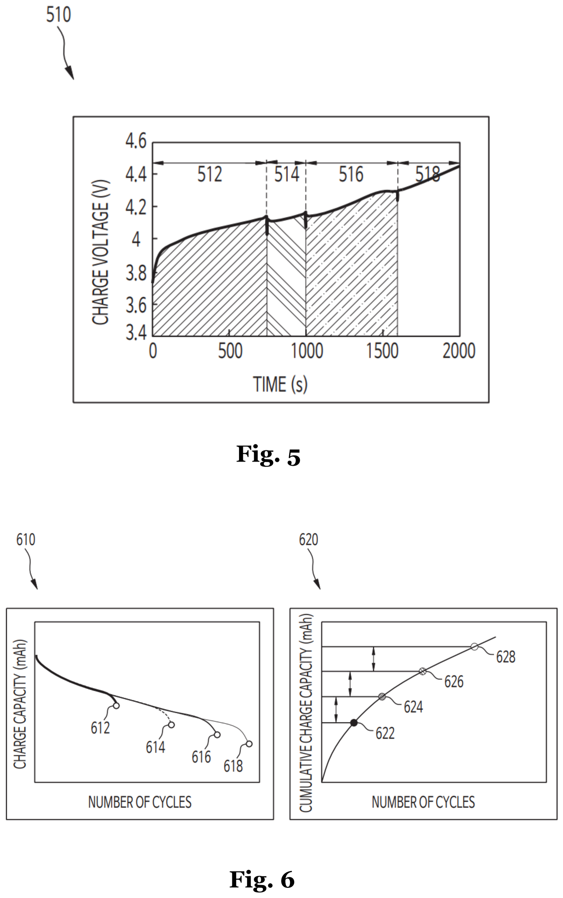

FIG. 5 illustrates multiple charging sections included in a charging pattern.

Referring to FIG. 5, a first graph 510 is a graph illustrating multiple charging sections included in a charging pattern. The multiple charging sections included in the first graph 510 may be part of one charge-discharge cycle of a battery. The charge-discharge cycle of the battery may include a first section 512, a second section 514, a third section 516, and a fourth section 518. The charging speed during the first section 512 is faster than the charging speed during the second section 514. The charging speed during the second section 514 is faster than the charging speed during the third section 516. The charging speed during the third section 516 is faster than the charging speed during the fourth section 518. Therefore, in the charge-discharge cycle, a discharged battery may first be charged at a high charging speed, and as the battery's charge voltage increases, the charging speed gradually decreases, forming a charging pattern.

FIG. 6 illustrates a relationship between an amount of an electrolyte injected and a charge capacity.

Referring to FIG. 6, a first graph 610 is a graph illustrating a relationship between the repetition count of the charge-discharge cycle and a charge capacity. The charge capacity may refer to the charge capacity in the first section 512 of FIG. 5. Each of curves 612 through 618 may represent the charge capacity during the life cycle of each of first through fourth batteries, which have different amounts of an injected electrolyte from each other. The amount of the electrolyte injected into the first battery associated with curve 612 is smaller than the amount of the electrolyte injected into the second battery associated with curve 614. The amount of the electrolyte injected into the second battery associated with curve 614 is smaller than the amount of the electrolyte injected into the third battery associated with curve 616. The amount of the electrolyte injected into the third battery associated with curve 616 is smaller than the amount of the electrolyte injected into the fourth battery associated with curve 618. Also, the difference between the amount of the electrolyte injected into the first battery and into the second battery may be equal to or substantially equal to each of the difference between the amounts injected into the second and third batteries, and the difference between the amounts injected into the third and fourth batteries.

Referring to the first graph 610, the first battery having the smallest amount of injected electrolyte shows a downward curve the earliest, and the fourth battery having the largest amount of injected electrolyte shows a downward curve the latest. This suggests that there is a correlation between the amount of the electrolyte injected and the life of the battery.

A second graph 620 is a graph illustrating a relationship between the repetition count of the charge-discharge cycle and a cumulative charge capacity. The cumulative charge capacity refers to a cumulative value obtained, over repeated charge-discharge cycles, for the charge capacity in the first section 512 of FIG. 5. The first point 622 may be associated with the first battery, the second point 624 may be associated with the second battery, the third point 626 may be associated with the third battery, and the fourth point 628 may be associated with the fourth battery. Referring to the second graph 620, the difference between the cumulative charge capacity of the first battery and that of the second battery is the same or substantially the same as each of the difference between the cumulative charge capacities of the second battery and the third battery, and the difference between the cumulative charge capacities of the third battery and the fourth battery. These differences correspond to the differences in the amounts of electrolyte injected into each battery. Accordingly, it may be inferred that the amount of the injected electrolyte and the cumulative charge capacity of the battery show a linear correlation.

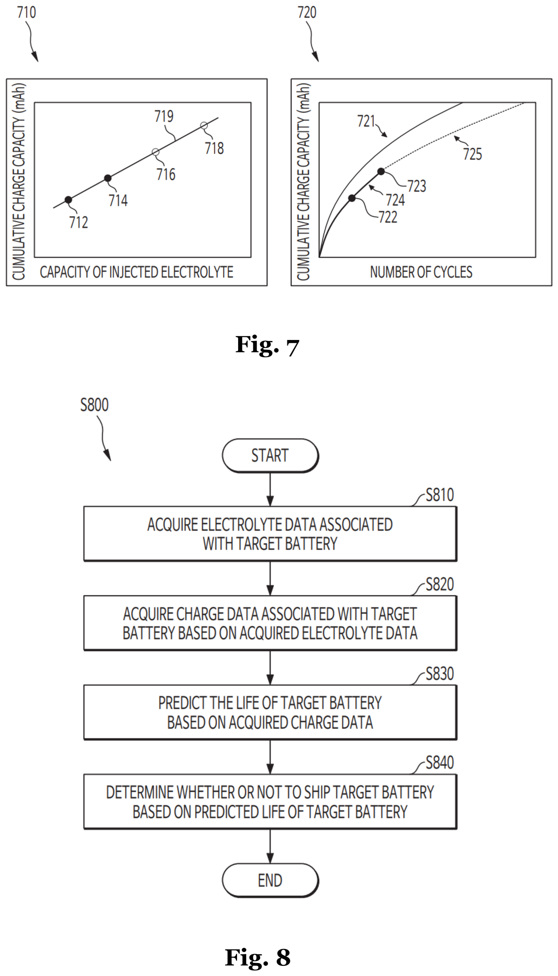

FIG. 7 illustrates a relationship between an amount of an electrolyte injected and the life of a battery.

Referring to FIG. 7, a linear function 719 may be derived through a first coordinate 712 and a second coordinate 714 of a first graph 710. The first coordinate 712 may be obtained from the amount of the electrolyte injected into a first battery and the cumulative charge capacity of the first battery, and the second coordinate 714 may be obtained from the amount of the electrolyte injected into a second battery and the cumulative charge capacity of the second battery. From the second graph 620 of FIG. 6 and the first graph 710 of FIG. 7, it can be seen that the amount of the electrolyte injected and the cumulative charge capacity show a linear correlation. Therefore, it may be inferred that the cumulative charge capacity of the target battery may be calculated based on the amount of the electrolyte injected into the target battery. For example, based on the linear function 719 and the amount of the electrolyte injected into the target battery, a third coordinate 716 may be obtained, and based on the third coordinate 716, the cumulative charge capacity of the target battery may be obtained.

A second graph 720 is a graph illustrating the relationship between the repetition count of the charge-discharge cycle and the cumulative charge capacity. The second graph 720 may include a reference graph 721 and a comparison graph 724. The reference graph 721 and the comparison graph 724 may be graphs experimentally obtained to show the relationship between the repetition count of the charge-discharge cycle and the cumulative charge capacity. The comparison graph 724 may be obtained based on a third coordinate 722 associated with the first battery and a fourth coordinate 723 associated with the second battery. In some embodiments, the first battery and the second battery may be batteries having design specifications that are the same or substantially the same as those of the target battery.

Based on the reference graph 721 and the comparison graph 724, a corrected graph 725, in which the reference graph 721 is corrected, may be estimated. In some embodiments, the corrected graph 725 may be estimated through a regression analysis. The life of the target battery may be predicted based on the corrected graph 725 and the cumulative charge capacity of the target battery.

FIG. 8 illustrates a flowchart showing an example of a battery life prediction method (S800) according to an embodiment of the present disclosure. The battery life prediction method (S800) may be performed by at least one processor. For example, the battery life prediction method (S800) may be performed by at least one processor 122 included in the information processing system 120 of FIG. 1.

Referring to FIG. 8, the battery life prediction method (S800) may start, and the processor may acquire electrolyte data associated with a target battery (S810). In some embodiments, the acquired electrolyte data associated with the target battery may include the capacity of the electrolyte injected into the target battery.

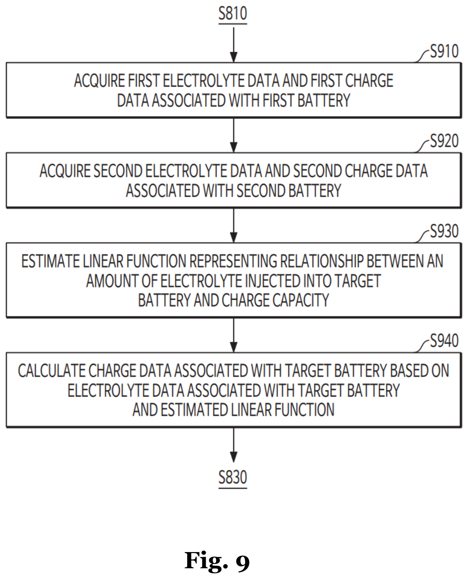

The processor may acquire charge data associated with the target battery based on the acquired electrolyte data (S820). The processor may acquire first electrolyte data associated with a first battery, may acquire second electrolyte data associated with a second battery, may acquire first charge data associated with the first battery, and may acquire second charge data associated with the second battery. The acquiring of the charge data associated with the target battery will be described in more detail below with reference to FIG. 9.

The processor may predict the life of the target battery based on the acquired charge data (S830). In some embodiments, based on at least one of the first charge data or the second charge data, the processor may estimate a reference graph representing a relationship between the repetition count of the charge-discharge cycle and a value obtained by accumulating the battery's charge capacity in a suitable section (e.g., a predetermined section) among multiple sections included in one charge-discharge cycle, as the charge-discharge cycle is repeated.

In some embodiments, the processor may acquire third charge data associated with a third battery and fourth charge data associated with a fourth battery. The acquired third charge data may be a value obtained by accumulating the charge capacity of the third battery in the section (e.g., the predetermined section) among multiple sections included in one charge-discharge cycle, as the charge-discharge cycles of the third battery are repeated. Also, the acquired fourth charge data may be a value obtained by accumulating the charge capacity of the fourth battery in the section (e.g., the predetermined section) among multiple sections included in one charge-discharge cycle, as the charge-discharge cycles of the fourth battery are repeated. Subsequently, based on at least one of the third charge data or the fourth charge data, the processor may estimate a comparison graph representing a relationship between the repetition count of the charge-discharge cycle and a value obtained by accumulating the battery's charge capacity in the section (e.g., the predetermined section) among multiple sections included in one charge-discharge cycle, as the charge-discharge cycle is repeated.

In some embodiments, the processor may generate a corrected graph by correcting the reference graph based on the reference graph and the comparison graph, and may estimate the life of the target battery based on the estimated charge data associated with the target battery and the generated corrected graph.

In some embodiments, the processor may determine whether or not to ship the target battery based on the predicted life of the target battery (S840), and the method S800 may end. The processor may determine whether or not the predicted life of the target battery is greater than or equal to a threshold (e.g., a predetermined threshold), and in response to determining that the predicted life of the target battery is greater than or equal to the threshold, the processor may transmit a command to a battery-manufacturing apparatus to ship the target battery.

FIG. 9 illustrates a flowchart showing an example of an operation for acquiring charge data associated with a target battery according to an embodiment of the present disclosure. The operation for acquiring the charge data associated with the target battery may be performed by at least one processor. For example, the operation for acquiring the charge data associated with the target battery may be performed by at least one processor 122 included in the information processing system 120 of FIG. 1. The operation for acquiring the charge data associated with the target battery may correspond to S820 of FIG. 8.

Referring to FIG. 9, the acquiring of the charge data associated with the target battery may include the processor acquiring first electrolyte data and first charge data associated with a first battery (S910). The processor may acquire second electrolyte data and second charge data associated with a second battery (S920).

Also, based on the first electrolyte data, the second electrolyte data, the first charge data, and the second charge data, the processor may estimate a linear function representing a relationship between an amount of the electrolyte injected into the target battery and a charge capacity (S930). The linear function may be estimated through an extrapolation.

Further, based on the electrolyte data associated with the target battery and the estimated linear function, the processor may calculate the charge data associated with the target battery (S940). In more detail, by substituting the electrolyte data associated with the target battery into the estimated linear function, the processor may calculate the charge data associated with the target battery. The charge data associated with the target battery may include a value estimated as the cumulative value, over repeated charge-discharge cycles of the target battery, of the charge capacity in the section (e.g., the predetermined section) among multiple sections included in one charge-discharge cycle.

However, the present disclosure is not limited to the flowcharts of FIGS. 8 and 9 described above. For example, one or more operations among the flowcharts may be added/changed/deleted, the order of one or more operations may be changed, one or more operations may be performed in an overlapping manner, and/or one or more operations may be repeated multiple times.

Although the present disclosure has been described above with respect to embodiments thereof, the present disclosure is not limited thereto. Various modifications and variations can be made thereto by those skilled in the art within the scope of the present disclosure and the equivalent scope of the appended claims.
The present disclosure additionally includes the following numbered embodiments:
Embodiment 1: A method (S800) for predicting a life of a battery, performed by at least one processor (122), the method (S800) comprising:
   acquiring (S810) electrolyte data associated with a target battery;
   acquiring (S820) charge data associated with the target battery based on the acquired electrolyte data; and
   predicting (S830) a life of the target battery based on the acquired charge data.
Embodiment 2: The method (S800) according to Embodiment 1, wherein the acquired electrolyte data comprises a capacity of an electrolyte injected into the target battery.
Embodiment 3: The method (S800) according to Embodiment 1 or 2, further comprising:
   acquiring (S910) first electrolyte data associated with a first battery;
   acquiring (S920) second electrolyte data associated with a second battery;
   acquiring (S910) first charge data associated with the first battery; and
   acquiring (S920), by the at least one processor (122), second charge data associated with the second battery,
   wherein the acquiring of the charge data associated with the target battery comprises estimating the charge data associated with the target battery based on the first electrolyte data, the second electrolyte data, the first charge data, the second charge data, and the electrolyte data associated with the target battery.
Embodiment 4: The method (S800) according to Embodiment 3, wherein the estimating of the charge data associated with the target battery comprises estimating a linear function (719) representing a relationship between an amount of an electrolyte injected into the target battery and a charge capacity, based on the first electrolyte data, the second electrolyte data, the first charge data, and the second charge data.
Embodiment 5: The method (S800) according to Embodiment 4, wherein the estimating of the charge data associated with the target battery further comprises calculating (S940) the charge data associated with the target battery based on the electrolyte data associated with the target battery and the estimated linear function (719).
Embodiment 6: The method (S800) according to Embodiment 4 or 5, wherein the linear function is estimated through an extrapolation method.
Embodiment 7: The method (S800) according to one of Embodiments 3 to 6, wherein the acquired first charge data comprises a value obtained by accumulating at least part of a charge capacity of the first battery over one charge-discharge cycle, as charge-discharge cycles of the first battery are repeated, and wherein the acquired second charge data comprises a value obtained by accumulating at least part of a charge capacity of the second battery over one charge-discharge cycle, as charge-discharge cycles of the second battery are repeated.
Embodiment 8: The method (S800) according to Embodiment 7, wherein the value obtained by accumulating the at least part of the charge capacity of the first battery over one charge-discharge cycle is a value obtained by accumulating, in a predetermined section among multiple sections included in the one charge-discharge cycle, the charge capacity of the first battery as charge-discharge cycles of the first battery are repeated,
   wherein the value obtained by accumulating the at least part of the charge capacity of the second battery over one charge-discharge cycle is a value obtained by accumulating, in the predetermined section among multiple sections included in the one charge-discharge cycle, the charge capacity of the second battery as charge-discharge cycles of the second battery are repeated, and wherein a charging speed in the predetermined section is the fastest among charging speeds of each of the multiple sections included in the charge-discharge cycle.
Embodiment 9: The method (S800) according to Embodiment 8, wherein the predicting (S830) of the life of the target battery comprises estimating a reference graph representing a relationship between a repetition count of the charge-discharge cycle and a value obtained by accumulating the battery's charge capacity in the predetermined section among the multiple sections included in the one charge-discharge cycle, as the charge-discharge cycle is repeated, based on at least one of the first charge data or the second charge data.
Embodiment 10: The method (S800) according to Embodiment 9, wherein the predicting (S830) of the life of the target battery further comprises:
   acquiring third charge data associated with a third battery, wherein the acquired third charge data is a value obtained by accumulating, in the predetermined section among multiple sections included in the one charge-discharge cycle, a charge capacity of the third battery, as charge-discharge cycles of the third battery are repeated;
   acquiring fourth charge data associated with a fourth battery, the fourth charge data being a value obtained by accumulating, in the predetermined section among multiple sections included in the one charge-discharge cycle, a charge capacity of the fourth battery, as charge-discharge cycles of the fourth battery are repeated;
   estimating a comparison graph representing a relationship between the repetition count of the charge-discharge cycle and a value obtained by accumulating the battery's charge capacity in the predetermined section among the multiple sections included in the one charge-discharge cycle, as the charge-discharge cycle is repeated, based on at least one of the third charge data or the fourth charge data; and
   generating a corrected graph by correcting the reference graph based on the reference graph and the comparison graph.
Embodiment 11: The method (S800) according to Embodiment 10, wherein the predicting (S830) the life of the target battery further comprises estimating the life of the target battery based on the estimated charge data associated with the target battery and the generated corrected graph.
Embodiment 12: The method (S800) according to one of Embodiments 1 to 11, further comprising determining (S840) whether to ship the target battery based on the predicted life of the target battery.
Embodiment 13: The method (S800) according to Embodiment 12, wherein the determining (S840) of whether to ship the target battery comprises:
   determining whether the predicted life of the target battery is greater than or equal to a predetermined threshold; and
   in response to determining that the predicted life of the target battery is greater than or equal to the predetermined threshold, transmitting a command to a battery-manufacturing apparatus to ship the target battery.
Embodiment 14: A non-transitory computer-readable recording medium storing a computer program for executing the method according to one of Embodiments 1 to 13.
Embodiment 15: A battery life prediction system (10), comprising:
   a memory (124); and
   at least one processor (122) connected to the memory (124), and configured to execute at least one computer-readable program included in the memory (124),
   wherein the at least one program comprises instructions to:
      acquire electrolyte data associated with a target battery;
      acquire charge data associated with the target battery based on the acquired electrolyte data; and
      predict a life of the target battery based on the acquired charge data.
Embodiment 16: The battery life prediction system (10) according to Embodiment 15, wherein the at least one program further comprises instructions to:
   acquire first electrolyte data associated with a first battery;
   acquire second electrolyte data associated with a second battery;
   acquire first charge data associated with the first battery;
   acquire second charge data associated with the second battery; and
   estimate charge data associated with the target battery based on the first electrolyte data, the second electrolyte data, the first charge data, the second charge data, and the electrolyte data associated with the target battery.
Embodiment 17: The battery life prediction system (10) according to Embodiment 16, wherein the at least one program further comprises instructions to:
   estimate a linear function representing a relationship between an amount of electrolyte injected into the target battery and a charge capacity, based on the first electrolyte data, the second electrolyte data, the first charge data, and the second charge data, and
   calculate the charge data associated with the target battery based on the electrolyte data associated with the target battery and the estimated linear function.
Embodiment 18: The battery life prediction system (10) according to Embodiment 16 or 17, wherein the at least one program further comprises instructions to:
   estimate a reference graph representing a relationship between a repetition count of a charge-discharge cycle and a value obtained by accumulating the battery's charge capacity in a predetermined section among multiple sections included in one charge-discharge cycle, as the charge-discharge cycle is repeated, based on at least one of the first charge data or the second charge data,
   wherein a charging speed in the predetermined section is the fastest among charging speeds of each of the multiple sections included in the charge-discharge cycle.
Embodiment 19: The battery life prediction system (10) according to Embodiment 18, wherein the at least one program further comprises instructions to estimate the life of the target battery based on the estimated charge data associated with the target battery and the estimated reference graph.
Embodiment 20: The battery life prediction system (10) according to one of Embodiments 15 to 19, wherein the at least one program further comprises instructions to:
   determine whether to ship the target battery based on the predicted life of the target battery, and
   transmit a command to a battery-manufacturing apparatus to ship the target battery.

## Claims

1. A method (S800) for predicting a life of a battery, the method (S800) comprising:
acquiring (S810), by at least one processor (122), electrolyte data associated with a target battery;
acquiring (S820), by the at least one processor (122), charge data associated with the target battery based on the electrolyte data; and
predicting (S830), by the at least one processor (122), a life of the target battery based on the charge data.

2. The method (S800) according to claim 1, wherein the electrolyte data comprises a capacity of an electrolyte injected into the target battery.

3. The method (S800) according to claim 1 or 2, further comprising:
acquiring (S910), by the at least one processor (122), first electrolyte data associated with a first battery;
acquiring (S920), by the at least one processor (122), second electrolyte data associated with a second battery;
acquiring (S910), by the at least one processor (122), first charge data associated with the first battery; and
acquiring (S920), by the at least one processor (122), second charge data associated with the second battery,
wherein the acquiring of the charge data associated with the target battery comprises estimating, by the at least one processor (122), the charge data associated with the target battery based on the first electrolyte data, the second electrolyte data, the first charge data, the second charge data, and the electrolyte data associated with the target battery.

4. The method (S800) according to claim 3, wherein the estimating of the charge data associated with the target battery comprises estimating, by the at least one processor (122), a linear function (719) representing a relationship between an amount of an electrolyte injected into the target battery and a charge capacity, based on the first electrolyte data, the second electrolyte data, the first charge data, and the second charge data.

5. The method (S800) according to claim 4, wherein the estimating of the charge data associated with the target battery further comprises calculating (S940), by the at least one processor (122), the charge data associated with the target battery based on the electrolyte data associated with the target battery and the linear function (719).

6. The method (S800) according to claim 4 or 5, wherein the linear function is estimated through an extrapolation method.

7. The method (S800) according to one of claims 3 to 6, wherein the first charge data comprises a value obtained by accumulating at least part of a charge capacity of the first battery over one charge-discharge cycle, as charge-discharge cycles of the first battery are repeated, and
wherein the second charge data comprises a value obtained by accumulating at least part of a charge capacity of the second battery over one charge-discharge cycle, as charge-discharge cycles of the second battery are repeated.

8. The method (S800) according to claim 7, wherein the value obtained by accumulating the at least part of the charge capacity of the first battery over one charge-discharge cycle is a value obtained by accumulating, in a section among multiple sections included in the one charge-discharge cycle, the charge capacity of the first battery as charge-discharge cycles of the first battery are repeated, wherein the value obtained by accumulating the at least part of the charge capacity of the second battery over one charge-discharge cycle is a value obtained by accumulating, in the section among multiple sections included in the one charge-discharge cycle, the charge capacity of the second battery as charge-discharge cycles of the second battery are repeated, and
wherein a charging speed in the section is the fastest among charging speeds of each of the multiple sections included in the charge-discharge cycle.

9. The method (S800) according to claim 8, wherein the predicting (S830) of the life of the target battery comprises estimating, by the at least one processor (122), a reference graph representing a relationship between a repetition count of the charge-discharge cycle and a value obtained by accumulating the battery's charge capacity in the section among the multiple sections included in the one charge-discharge cycle, as the charge-discharge cycle is repeated, based on at least one of the first charge data or the second charge data.

10. The method (S800) according to claim 9, wherein the predicting (S830) of the life of the target battery further comprises:
acquiring, by the at least one processor (122), third charge data associated with a third battery, the third charge data being a value obtained by accumulating, in the section among multiple sections included in the one charge-discharge cycle, a charge capacity of the third battery, as charge-discharge cycles of the third battery are repeated;
acquiring, by the at least one processor (122), fourth charge data associated with a fourth battery, the fourth charge data being a value obtained by accumulating, in the section among multiple sections included in the one charge-discharge cycle, a charge capacity of the fourth battery, as charge-discharge cycles of the fourth battery are repeated;
estimating, by the at least one processor (122), a comparison graph representing a relationship between the repetition count of the charge-discharge cycle and a value obtained by accumulating the battery's charge capacity in the section among the multiple sections included in the one charge-discharge cycle, as the charge-discharge cycle is repeated, based on at least one of the third charge data or the fourth charge data; and
generating, by the at least one processor (122), a corrected graph by correcting the reference graph based on the reference graph and the comparison graph.

11. The method (S800) according to claim 10, wherein the predicting (S830) of the life of the target battery further comprises estimating, by the at least one processor (122), the life of the target battery based on the estimated charge data associated with the target battery and the corrected graph.

12. The method (S800) according to one of claims 1 to 11, further comprising determining (S840), by the at least one processor (122), whether or not to ship the target battery based on the predicted life of the target battery.

13. The method (S800) according to claim 12, wherein the determining (S840) of whether or not to ship the target battery comprises:
determining, by the at least one processor (122), whether or not the predicted life of the target battery is greater than or equal to a threshold; and
in response to determining that the predicted life of the target battery is greater than or equal to the threshold, transmitting, by the at least one processor (122), a command to a battery-manufacturing apparatus to ship the target battery.

14. A battery life prediction system (10), comprising:
a memory (124); and
at least one processor (122) connected to the memory (124), and configured to execute at least one computer-readable program included in the memory (124), wherein the at least one computer-readable program comprises instructions that, when executed by the at least one processor (122), cause the at least one processor (122) to:
acquire electrolyte data associated with a target battery;
acquire charge data associated with the target battery based on the electrolyte data; and
predict a life of the target battery based on the charge data.

15. The battery life prediction system (10) according to claim 14, wherein the at least one program further comprises instructions that cause the at least one processor (122) to:
acquire first electrolyte data associated with a first battery;
acquire second electrolyte data associated with a second battery;
acquire first charge data associated with the first battery;
acquire second charge data associated with the second battery; and
estimate charge data associated with the target battery based on the first electrolyte data, the second electrolyte data, the first charge data, the second charge data, and the electrolyte data associated with the target battery.
